# EUROPEAN PATENT SPECIFICATION

(11) **EP 4 189 752 B1**
(45) Date of publication and mention of the grant of the patent: **28.10.2026**
(21) Application number: 21745972.6
(22) Date of filing: 15.07.2021
(51) Int. Cl.: H10H 20/855, H10H 20/85, H10W 90/00, H10F 77/50, H10F 55/00

(54) **ASSEMBLY FOR A SEMICONDUCTOR PHOTONIC COMPONENT**
ANORDNUNG FÜR EINE PHOTONISCHE HALBLEITERKOMPONENTE
ENSEMBLE POUR UN COMPOSANT SEMICONDUCTEUR PHOTONIQUE

(30) Priority: 27.07.2020 EP 20187825
(43) Date of publication of application: 07.06.2023
(73) Proprietor: Signify Holding B.V., 5656 AE Eindhoven (NL)
(72) Inventor: BUKKEMS, Peter Johannes Martinus, 5656 AE Eindhoven (NL); MOS, Barry, 5656 AE Eindhoven (NL)
(74) Representative: Verweij, Petronella Daniëlle
(86) International application number: PCT/EP2021/069786
(87) International publication number: WO 2022/023056

(56) References cited:
- EP-A1- 1 858 086
- EP-A1- 2 535 954
- EP-A1- 3 547 378
- WO-A1-2008/117800
- WO-A1-2020/127163
- US-A1- 2012 063 141
- US-A1- 2019 207 051

## Description

### TECHNICAL FIELD

The invention relates to an assembly for a semiconductor photonic component, wherein the semiconductor photonic component is accommodated in an assembly housing being shielded from the environment. Furthermore, the invention relates to an assembly housing for use with such assembly for a semiconductor photonic component. Additionally, the invention relates to a housing wall part for use in an assembly housing. Finally, the invention relates to a lighting device comprising said assembly.

A lighting device comprising a light transmissive light guiding plate covering light emitting elements such as light emitting diodes is known from EP 3 547 378 A1.

### BACKGROUND OF THE INVENTION

Semiconductor photonic components are key parts in the field of light (photon) generation, detection, and manipulation through emission, transmission, modulation, signal processing, switching, amplification, and sensing. When implemented in sensing equipment, it is required to have the semiconductor photonic components properly sealed and protected against the external environment. Thus, it is common to house such photonic components in a sealed manner in an assembly housing in order to protect the sensitive components against a hazardous environment, such as water (moisture), chemicals, dust, etc.

It is known to mount such photonic components with sealing components or gaskets in or to the assembly housing preventing exposure of the photonic component to the hazardous external environment. However, such sealing measures do affect the functionality and accuracy of the photonic component, requiring counter measures for improving the accuracy. Additionally, the performance of semiconductor photonic components is also affected due to interaction with other electronic components of the sensing equipment.

Thus there is a need for an improved mounting and sealing technique for a semiconductor photonic component in an assembly housing, both providing a proper sealing against the environment as well as avoiding interference and unwanted noise from adjacent circuitry, which otherwise would adversely affect the accuracy of the photonic component.

### DESCRIPTION OF THE INVENTION

Accordingly, an assembly for a semiconductor photonic component is proposed, with the assembly at least comprising a substrate; at least one semiconductor photonic component mounted to the substrate, said at least one semiconductor photonic component including a photonic active surface element; an assembly housing for shielding the substrate and the at least one semiconductor photonic component from the environment; the assembly housing comprises a housing wall part having an exterior surface provided with at least one photonic window element facing the photonic active surface element of the at least one semiconductor photonic component, said at least one photonic window element being a bottom wall of a recess in said exterior surface and forming a monolithic part with the housing wall part, wherein the at least one photonic window element has a thickness which is smaller than the thickness of the housing wall part for having a transmissivity being larger than the transmissivity of the housing wall part, wherein the housing wall part contains a light absorbing dope and/or light blocking dope.

By the photonic window element being the bottom of a recess, easier control is obtained of the screening or critical angle at which ambient light can directly imping, i.e. without being transmitted or reflected by other housing wall parts than the photonic window element, on the photonic element, thus better defining boundaries of, for example sensing, a target area. This screening or critical angle can further easily be controlled by the depth and/or width to depth ratio of the recess. The assembly for a semiconductor photonic component may have the feature that the recess has a side wall at least partly formed by upright housing wall sections and has a depth D which is larger than the thickness T of the housing wall part. In the description, the recess may also be referred to as cavity. Furthermore, the assembly for a semiconductor photonic component may have the feature that the recess has a width W at the exterior surface and depth D, wherein W/D is such that only light rays can directly imping on the at least one photonic window at an angle smaller than a critical angle βcritic , wherein βcritic <= 40°, preferably <= 25°, more preferably <= 20°.

As the photonic window element is formed as an integral, monolithic part of the assembly housing no additional sealing measures are required. Furthermore as the photonic window element has a transmissivity for light, which is larger than the transmissivity of the housing wall part directly adjacent to the photonic window element, the functionality and accuracy of the semiconductor photonic component directly facing the photonic window element is not adversely affected. In addition, as the transmissivity of the housing wall part directly adjacent to the photonic window element is smaller than that of the photonic window element the semiconductor photonic component is not susceptible to interference and unwanted noise from its adjacent circuitry in the assembly housing, nor to stray noise from the outside environment.

In a preferred example of the assembly, the at least one photonic window element has a transmissivity of at least 10%, preferably between 10% and 30% and the housing wall part has a transmissivity of at the most 10%, preferably between 10% and 1%, in particular at the most of 3%.

As mentioned, the at least one photonic window element has a thickness which is smaller than the thickness of the housing wall part and the housing wall part contains a dope that can be a light absorbing and/or light blocking dope.

In both examples, the functionality and accuracy of the semiconductor photonic component directly facing the photonic window element functions properly, and is not adversely affected by interference or noise from adjacent circuitry in the housing or from stray signals from the outside environment.

Preferably, the housing wall part is provided with a cavity accommodating the at least one photonic window element, with the housing wall part further comprising an upright housing wall section surrounding the cavity. Herewith a further constructional sealing of the semiconductor photonic component facing the photonic window element in the assembly housing is obtained, preventing interference, noise, and stray signalling from both inside the assembly housing (due to the adjacent circuitry) as from the outside environment.

Preferably, the assembly housing is made from a light transmissive material chosen from the group of polycarbonate, PMMA, polystyrene, etc.

In a further example the housing wall part is formed integrally with the assembly housing and in particular the housing wall part and the assembly housing form a monolithic part.

In yet another example the housing wall part is formed as an insert element in the assembly housing.

In an example, the at least semiconductor photonic element is a light emitting element, in particular a LED, whereas in another example the at least semiconductor photonic element is a light sensing element. In particular, the light sensing element is a photodiode, a phototransistor, or a photovoltaic cell.

The invention also pertains to an assembly housing for use with an assembly for a semiconductor photonic component as defined in the invention, wherein the assembly housing comprises a housing wall part provided with at least one photonic window element facing a photonic active surface element of the at least one semiconductor photonic component, with said at least one photonic window element forming a monolithic part with the housing wall part and having a transmissivity being larger than the transmissivity of the housing wall part.

Additionally, the at least one photonic window element has a transmissivity of at least 10%, preferably between 10% and 30% and the housing wall part has a transmissivity of at the most 10%, preferably between 10% and 1%, in particular at the most of 3% or the at least one photonic window element has a thickness which is smaller than the thickness of the housing wall part. In another functional embodiment of the assembly the housing wall part contains a light blocking dope and/or a light absorbing dope.

In both examples, the functionality and accuracy of the semiconductor photonic component directly facing the photonic window element functions properly, and is not adversely affected by interference or noise from adjacent circuitry in the housing or from stray signals from the outside environment.

Preferably, the housing wall part is provided with a cavity accommodating the at least one photonic window element, with the housing wall part further comprising an upright housing wall section surrounding the cavity. Herewith a further constructional sealing of the semiconductor photonic component facing the photonic window element in the assembly housing is obtained, preventing interference, noise, and stray signalling from both inside the assembly housing (due to the adjacent circuitry) as from the outside environment.

Preferably, the assembly housing is made from a light transmissive material chosen from the group of polycarbonate, PMMA, polystyrene, etc.

The invention further relates to a lighting device comprising the assembly according to the invention, the lighting device typically is a flood light, spotlight, or luminaire such as a wall mounted luminaire, a recessed luminaire, as suspended luminaire, and a free standing luminaire.

### DESCRIPTION OF THE DRAWINGS

The invention will now be discussed with reference to the drawings, which show in:
Figures 1-5 schematically illustrate examples of embodiments of an assembly and an assembly housing according to the present disclosure;
Figure 6 schematically illustrates an example of the optical efficiency (in %) of the integral, monolithic housing wall part according to the invention; and
Figure 7 schematically illustrates an example of a luminaire according to the invention.

### DETAILED DESCRIPTION OF THE DRAWINGS

For a proper understanding of the invention, in the detailed description below corresponding elements or parts of the invention will be denoted with identical reference numerals in the drawings.

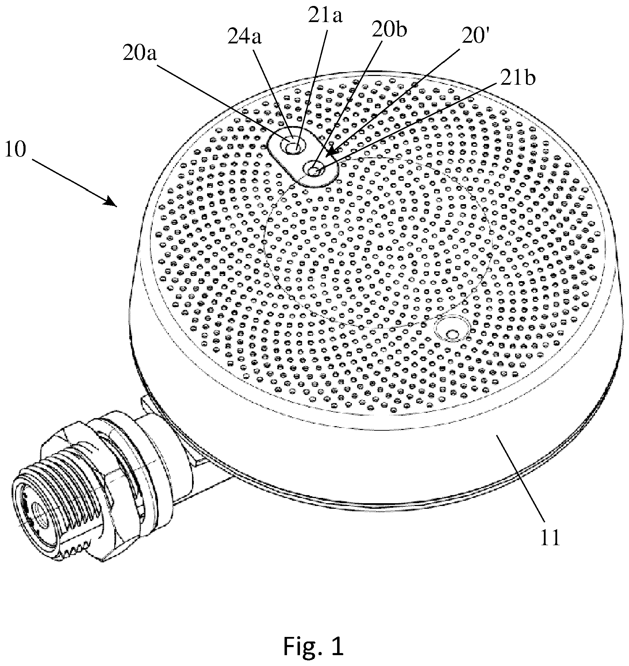

Figures 1-5 schematically illustrate non-limiting examples of embodiments of an assembly and an assembly housing according to the present disclosure.

The assembly for at least one semiconductor photonic component is in general fashion denoted with reference numeral 10. It is to be understood in this patent application that the assembly for the at least one semiconductor photonic component can perform different and even combined photonic applications in the range of visible and near-infrared light, such as light (photon) generation, detection, and manipulation through emission, transmission, modulation, signal processing, switching, amplification, and sensing.

In this patent application examples are described of an assembly incorporating one or more semiconductor photonic components capable of light sensing and light emission. However, also other examples are considered feasible, in combination with the configurations of the assembly housing described hereafter.

The assembly 10 is constructed as a module containing suitable electronic circuitry and one or more semiconductor photonic components. The module of the assembly 10 is for example arranged to be mounted to a device for measurement purposes. However, the assembly 10 can also be used as a stand-alone module.

Usually such assemblies 10 are used in hazardous environments, where either high (or low) temperatures and pressures can occur and/or as where water (moisture), chemicals, dust or other aggressive and/or abrasive and/or corrosive media. Therefor the assembly 10 needs to properly seal and protect the electronic components, such as the circuitry and the semiconductor photonic components against these external influences. It is common to house these sensitive parts (circuitry and photonic components) in a sealed manner in an assembly housing using sealing components or gaskets in or to the assembly housing, thus preventing exposure of the sensitive parts and in particular the photonic component to the hazardous external environment.

However, such sealing measures do affect the functionality and accuracy of the photonic component, requiring counter measures for improving the accuracy. Additionally, the performance of semiconductor photonic components is also affected due to interaction with other electronic components of the sensing equipment.

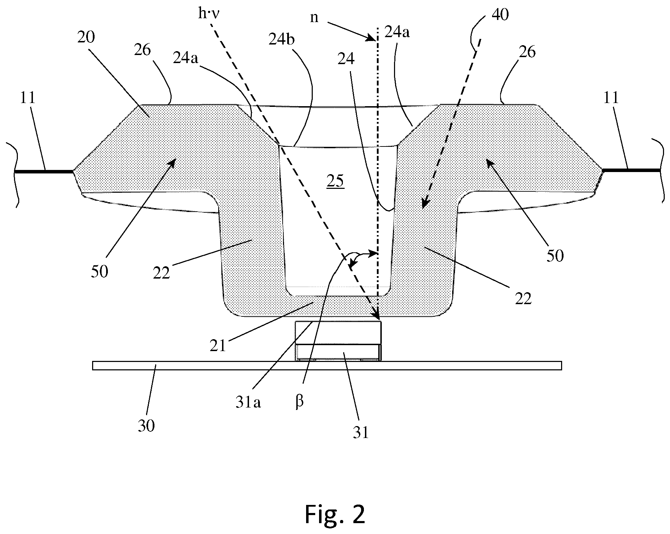

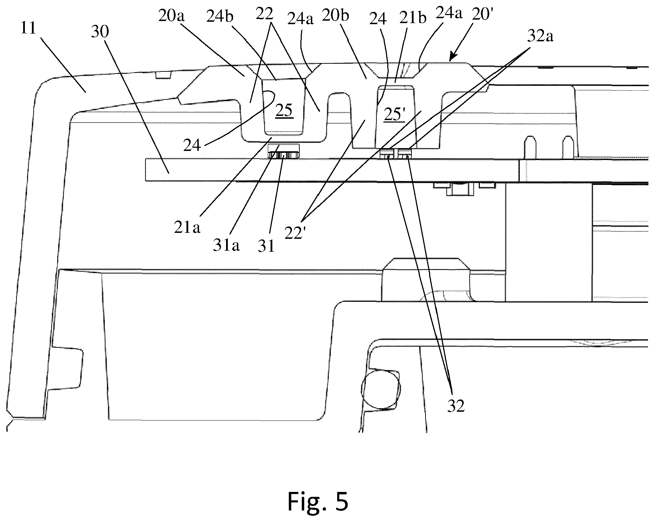

As shown in Figures 2-5 the assembly 10 houses a substrate or printed circuit board (PCB circuitry) 30 on which the necessary electronic components are mounted for data collection and processing. The PCB 30 also houses at least one semiconductor photonic element, indicated with reference numeral 31 in Figures 2, 3 and 4, and with reference numerals 31 and 32 in Figure 5.

As outlined the at least one semiconductor photonic element 31 and 32 can be used for many applications in the range of visible and near-infrared light, such as light (photon) generation, detection, and manipulation through emission, transmission, modulation, signal processing, switching, amplification, and sensing. In the embodiment of Figures 2-5 the semiconductor photonic element (of a first type) 31 is implemented as a light detecting element, whereas the semiconductor photonic element (of a second type) 32 in Figure 5 is implemented as light emitting elements, in particular one or more LEDs. As a general remark is it noted, that for the sensor type, the light sensing type should be able to receive a sufficient amount of light, while for a light emitting type, the light should be visible for the user.

Both examples of semiconductor photonic elements (of the first and second type) 31 and 32 include a photonic active surface element, indicated with reference numeral 31a and 32a, respectively.

Reference numeral 11 depicts an assembly housing of the assembly 10, which assembly housing 11 serves as a shielding for the substrate 30 and the at least one semiconductor photonic component 31-32 from the environment, as shown in Figure 1 and in detail in the Figures 2-5.

The assembly housing 11 comprises a housing wall part, indicated with reference numeral 20' in Figures 1 and 5 and with reference numeral 20 in Figures 2, 3 and 4. The housing wall part 20 respectively is provided with one photonic window element 21 in the examples of Figures 2, 3 and 4. In Figures 1 and 5 the housing wall part 20' is provided with a first and second assembly housing wall section parts 20a-20b respectively, each assembly housing wall section part 20a-20b being provided with a photonic window element 21a and 21b, respectively. It will be clear that multiple photonic window elements (more than two, such as three or four or even more) can be present in the housing wall part 20-20' or even present in multiple housing wall parts 20-20' of the assembly 10 depending on its photonic application.

Each photonic window element 21 (21a-21b) faces the photonic active surface element 31a (32a) of the respective semiconductor photonic component 31-32 mounted to the PCB substrate 30. Herewith the semiconductor photonic component 31 (acting as a light detecting element) is capable for sensing light impinging on the photonic window element 21-21a under a certain impinging angle β or can light being emitted by the semiconductor photonic component 32 (acting as a light emitting element, LED) exit the photonic window element 21b.

In the examples depicted, the assembly housing 11 / the housing wall part 20-20' can be provided with photonic entry/exit cavities 25-25', both cavities 25-25' being formed by photonic window element 21 (21a-21b) and upright housing wall sections 22-22' surrounding the cavities 25-25'. The cavities 25-25' serve as entry or exit areas for light entering or exiting the assembly 10 through the respective photonic window elements 21 (21a-21b).

Usually in the prior art, such photonic window element 21 (21a-21b) is mounted in a sealed manner in the assembly housing by means of additional sealing means such as a sealing gasket. However, such sealing measures do affect the functionality and accuracy of the photonic component 21 (21a-21b), requiring counter measures for improving the accuracy. Such counter measures may incorporate increasing the photonic window element, which however might result in capturing noisy and stray light (in the example of a light sensing element as the photonic component 21. Another counter measure for improving the accuracy of the photonic element 21 (functioning as a light sensing element) is blackening the surfaces 24 of the upright housing wall sections 22 surrounding the entry cavity 25.

In an application of the assembly 10, wherein the photonic component 21 acts as a light sensing element, the entry surfaces 24 of the upright housing wall sections 22-22' are often blackened in an additional process step. This blackening is performed in order limit the influence of light entering under different impinging angles β the cavity 25 from outside the target area directly facing the photonic window element 21 and the photonic active surface element 31a of the semiconductor photonic component 31 (light sensing element).

However, such additional blackening process step is practically cumbersome because of the very small dimensions (diameter and depth) of the entry cavity 25 and the risk of damaging or blackening the photonic window element 21, which results in a reduced sensing performance of the light sensing element 31.

A same consideration applies to the exit cavity 25' (Figure 5) being formed and surrounded by the upright housing wall section 22' and the photonic window element 21b, the latter facing the photonic active surface element 32a of the light emitting elements 32.

Accordingly, in the present invention the photonic window element 21a-21b forms a monolithic part with the housing wall part 20-20' (20a-20b) and has a transmissivity being larger than the transmissivity of the housing wall part 20-20'. By forming the photonic window element 21a-21b as an integral, monolithic part of the housing wall part 20-20' and the assembly housing 11 no additional sealing measures are required. Furthermore as the photonic window element 21a-21b has a transmissivity for light, which is larger than the transmissivity of the housing wall parts 20-20' and in particular the upright housing wall sections 22-22' directly adjacent to the photonic window element 21a-21b, the functionality and accuracy of the semiconductor photonic component 31-32 directly facing the photonic window element 21a-21b is not adversely affected.

In addition, as the transmissivity of parts of the housing wall part 20-20' (upright housing wall sections 22-22') directly adjacent to the photonic window element 21a-21b is smaller than that of the photonic window element 21a-21b itself, the semiconductor photonic component 31-32 is not susceptible to interference and unwanted noise from its adjacent circuitry mounted on the PCB substrate 30 in the assembly housing, nor to stray noise from the outside environment.

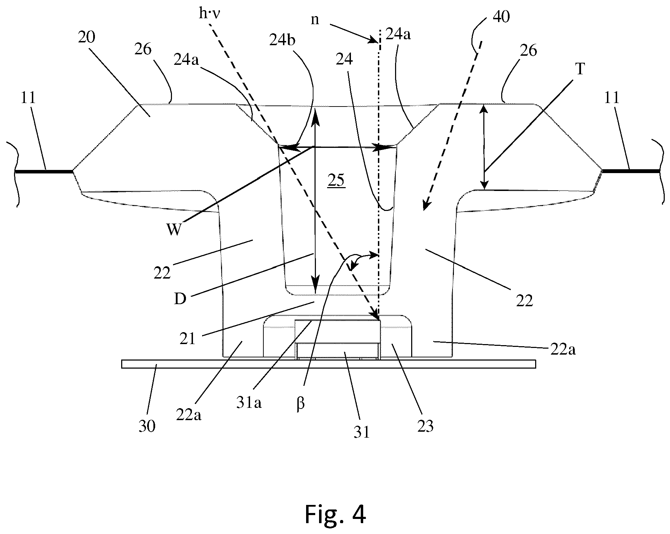

This latter advantage is further improved by providing the housing wall part 20-20' with an additional mounting cavity 23 (see Figure 4) in which the semiconductor photonic element 31 is accommodated. The mounting cavity 23 is formed and surrounded by the PCB substrate 30, the photonic window element 21a and additional upright housing wall sections 22a, which upright housing wall sections 22a are an extension of the upright housing wall section 22.

Herewith the performance and accuracy of the semiconductor photonic element 31, which can be a light sensing element 31, is not adversely influenced by for example stray light being emitted by a light emitting element 32, which is mounted directly next to this light sensing element 31 on the same PCB substrate 30. Accordingly, the light sensing element 31 will sense only light from the target area directly facing and entering via the chamfer surface 24a and the chamfer transition line 24b the entry cavity 25 and the light sensing element 31 will sense only that light due to the lower transmissivity of the housing wall part 20-20' in particular the upright housing wall sections 22-22' and the higher transmissivity of the photonic window element 21a.

In an example, the integral, monolithic constructional housing wall part 20-20' including the photonic window element 21a-21b is formed integrally with the assembly housing, in particular the housing wall part 20-20' and the assembly housing 11 form a monolithic part. This embodiment is for example depicted in Figure 2 and Figure 4, wherein the assembly housing 11 and the housing wall part 20-20' are manufactured for example by means of plastic (injection) moulding.

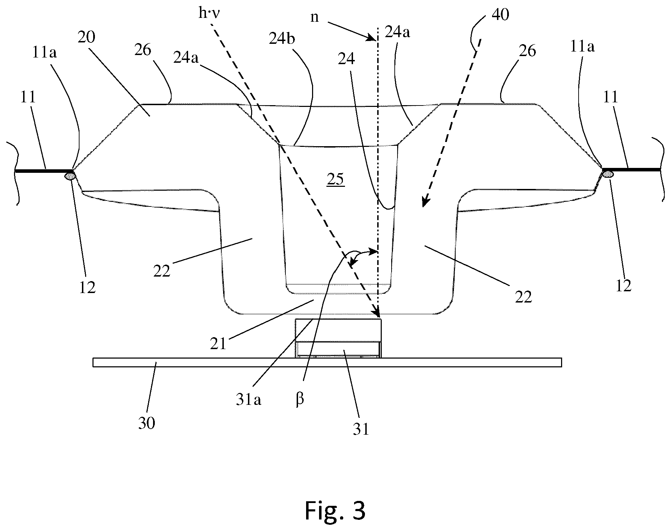

In another examples, the housing wall part 20-20' is formed as an insert element in the assembly housing 11. These embodiments are for example shown in Figures 3 and 5, wherein the assembly housing 11 is provided with a mounting hole or opening 11a. The inner dimensions of the mounting opening 11a are conformal to an outer dimension of the housing wall part 20-20' allowing the housing wall part 20-20' to be mounted in the mounting opening 11a either by means of a click or snap connection or by means of a glue 12.

Preferably, the photonic window element 21a-21b and the housing wall part 20-20', forming one integral, monolithic constructional part, are made from the same material, preferably a light transmissive plastic material chosen from the group of polycarbonate, PMMA, polystyrene, styrene-acrylonitrile, polypropylene, silicone, polyurethane, etc. Such plastic materials can be easily processed for example by means of plastic (injection) moulding.

In an embodiment the at least one photonic window element 21a-21b has a transmissivity of at least 10% and the remaining housing wall part 20-20' and in particular the upright housing wall sections 22-22' and the additional upright housing wall section 22a has a transmissivity of at the most 1%.

As the entire integral, monolith part composed of the housing wall part 20-20' (20a-20b) including one or more photonic window elements 21a-21b-... -etc. preferably is manufactured from the same plastic material, the difference in transmissivity between the photonic window element 21a-21b and the rest of the housing wall part 20-20' (20a-20b) is , in accordance with the invention as claimed, established, by providing the at least one photonic window element 21a-21b with a thickness which is smaller than the thickness of the housing wall part directly adjacent to it, that is the upright housing wall sections 22-22' and the additional upright housing wall section 22a.

In addition, according to the invention as claimed, for establishing said difference in transmissivity the housing wall part directly adjacent to the at least one photonic window element 21a-21b contains a light absorbing or blocking dope. In one embodiment, the material forming the housing wall part 20-20' (20a-20b) excluding the photonic window elements 21a-21b is provided a light absorbing or blocking dope. In another embodiment, only the material of parts of the housing wall part 20-20' (20a-20b) directly adjacent to the photonic window elements 21a-21b, hence the upright housing wall sections 22-22' and the additional upright housing wall section 22a, are provided with such light absorbing or blocking dope.

Suitable light absorbing or blocking dopes added to the material of the housing wall part are carbon black, graphite, or colour dies. Also diffuse materials could be used, such as additives or materials having a lower or higher index of refraction than the base material of the of the housing wall part 20-20', Examples of such materials having a lower or higher index of refraction are silicone particles, TiO₂ particles, etc. which particles lower the light transmission from and to the faces the photonic active surface element 31a (32a) of the respective semiconductor photonic component 31-32 mounted to the PCB substrate 30.

Also, combinations of a light absorbing dope and light scattering dope could be used.

A combination of both examples of establishing said difference in transmissivity is defined for the embodiments according to the invention: thus an integral, monolith part composed of the housing wall part 20-20' (20a-20b) including one or more photonic window elements 21a-21b implementing both a difference in thickness as well as the use of a light absorbing or blocking dope as described above.

Figure 2 depicts in a schematic manner the presence of the light absorbing or blocking dope as reference numeral 50 in the upright housing wall sections 22 surrounding the entry cavity 25 and next to the photonic window element 21, in which the light absorbing or blocking dope 50 is absent. Note that in the embodiments of Figure 3-5 the light absorbing or blocking dope 50 can be provided in a similar manner to the material of the housing wall part 20-20', which material form the upright housing wall sections 22-22' and the additional upright housing wall section 22a.

Light, in Figures 2-4 depicted as light beam 40, impinging on the exterior surface 26 of the housing wall part 20-20' directly adjacent to the entry cavity 25, will thus be absorbed by the light absorbing or blocking dope 50 contained in the housing wall sections 22, thereby preventing the light beam 40 from penetrating fully through the housing wall sections 22 and reaching the photonic active surface element 31a of the semiconductor photonic elements 31, either directly or via the entry cavity 25 and the photonic window elements 21.

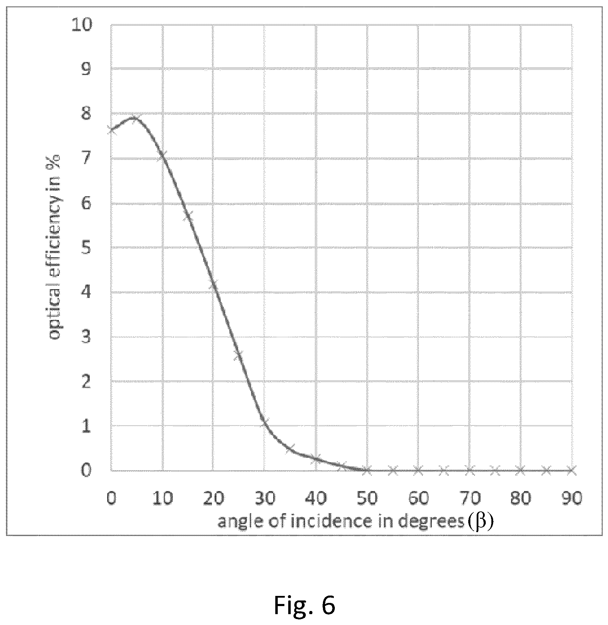

Figure 6 depicts an experimental result of the assembly 10 and in particular the assembly housing 11 according to the invention. The graph shows along its vertical (y) axis the optical efficiency (in %) of the integral, monolithic housing wall part 20 (20a) provided with a photonic window element 21a exhibiting a difference in transmissivity as described above. The horizontal (x) axis shows the angle β between light impinging the photonic active surface element 31a and the normal line n perpendicular to the surface of the photonic active surface element 31a. The photonic window element 21a-21b (as well as the interacting entry cavity 25) are facing a target area from which light originates, which light is captured and detected by the photonic active surface element 31a of semiconductor photonic element (light sensing element) 31.

The graph in Figure 6 shows the effect of reduced/limited transmissivity of the material of the surface 24 of the upright housing wall section 22 surrounding the entry cavity. Light entering the cavity 24 and impinging under small angles of incidence 0° < β < 25° relative to the normal line n surface 24 of the upright housing wall section 22 can still impinge on the photonic window element 21a and be detected the semiconductor photonic component 31.

Due to the reduced transmissivity and in particular due to the light absorbing or blocking dope in the material of the upright housing wall section 22 surrounding the cavity 25 as well the dimensions, height/depth D (at least partly formed by upright wall sections 24) and diameter/width W (at the exterior surface 26), and the ratio W/D of the cavity 25 are such that light impinging on the upright housing wall section 22 under an angle of incidence β > 20-25° is directly absorbed by the upright housing wall section 22 and will not impinge on the photonic window element 21a and thus not detected by the semiconductor photonic component 31. Furthermore, as shown, the depth D of the cavity/recess 25 is larger than the thickness T of the housing wall part 20. This critical angle β_{critic} is for example shown in the Figures 2 and 3 by means of the h·v arrow, which indicates a light beam entering the cavity 25 whilst grazing the chamfer surface 24a and the chamfer transition line 24b and which is thus barely sensed/detected by the photonic active surface element 31a of the semiconductor photonic sensing element 31.

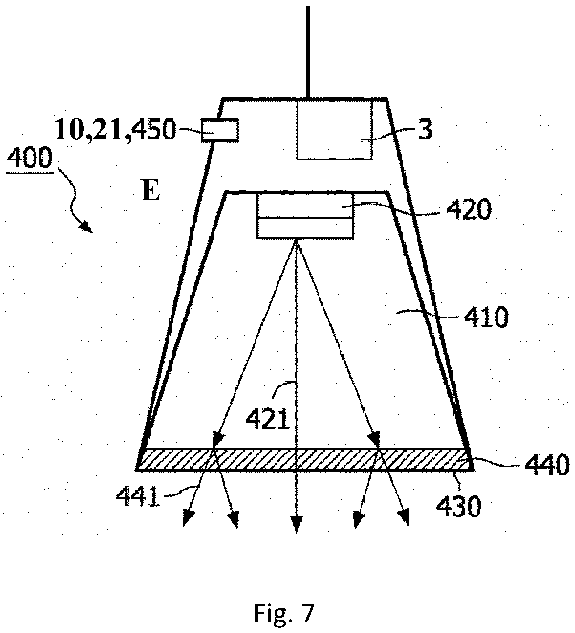

Figure 7 shows a suspended down-light luminaire 400 suitable for indoor illumination purposes. The luminaire 400 comprises an optical cavity 410 in which at least one LED 420 is assembled. The LEDs 420 are able to emit LED light 421. Furthermore, the luminaire 400 comprises a transparent window 430 covering the optical cavity 410 through which the light generated by the LED(s) 420 can be transmitted. The window 430 is provided with a diffusing coating or layer 440, for instance through silkscreen printing, spin coating or any other appropriate coating technology known in the art, rendering light 421 to be issued from the luminaire as diffused light 441. The luminaire 400 comprises an assembly 10 according to the invention, said assembly comprising a light sensing element 21, in the figure a photo sensor 450, to detect ambient lighting level E of the environment. The control means 3 adjusts the residual current to the LED(s) 420 in relation to the lighting level E, based on the sensor signal. This is beneficial, as higher ambient lighting levels require a larger residual current in order to outshine the reflected ambient light. Moreover, at lower ambient lighting levels the residual current can be reduced making the luminaire 400 more energy efficient. In fact, the residual current can be set to zero below a predetermined ambient lighting level.

### LISTING OF REFERENCE NUMERALS USED

- 3: control means
- 10: assembly for a semiconductor photonic component
- 11: assembly housing
- 11a: mounting opening in assembly housing
- 12: click / snap connection - glue
- 20: housing wall part (Figures 2 and 3 and 4)
- 20': housing wall part (Figures 1 and 5)
- 20a: first assembly housing wall part (Figures 1 and 5)
- 20b: second assembly housing wall part (Figures 1 and 5)
- 21: photonic window element (Figures 2 and 3 and 4)
- 21a: photonic window element of the first type (Figures 1 and 5)
- 21b: photonic window element of the second type (Figures 1, 3 and 4)
- 22-22': upright housing wall section of housing wall part
- 22a: additional upright housing wall section of housing wall part
- 23: mounting cavity in housing wall part
- 24: entry surfaces of upright housing wall section
- 24a: chamfer surface of entry cavity 25
- 24b: chamfer transition line
- 25: entry cavity in housing wall part
- 25': exit cavity in housing wall part
- 26: exterior surface of housing wall part
- 30: substrate or printed circuit board or circuitry
- 31: semiconductor photonic element of the first type (sensing type)
- 31a: photonic active surface element of semiconductor photonic element of the first type
- 32: semiconductor photonic element of the second type (emitting type)
- 32a: photonic active surface element of semiconductor photonic element of the second type
- 40: light beam
- 50: light absorbing or blocking dope
- 400: luminaire
- 410: optical cavity
- 420: LED
- 421: LED light
- 430: window
- 440: diffusing coating or layer
- 441: diffused light
- 450: photo sensor
- E: ambient lighting level

## Claims

1. An assembly (10) for a semiconductor photonic component (31, 32), the assembly at least comprising:
- a substrate (30);
- at least one semiconductor photonic component (31, 32) mounted to the substrate, said at least one semiconductor photonic component including a photonic active surface element (31a, 32a);
- an assembly housing (11) for shielding the substrate and the at least one semiconductor photonic component from the environment;
the assembly housing comprises a housing wall part (20, 20') having an exterior surface (26) and being provided with at least one photonic window element (21) facing the photonic active surface element (31a, 32a) of the at least one semiconductor photonic component, said at least one photonic window element being a bottom wall of a recess (25) in said exterior surface and forming a monolithic part with the housing wall part (20, 20'),
wherein the at least one photonic window element (21) has a thickness which is smaller than the thickness of the housing wall part directly adjacent to the at least one photonic window element for having a transmissivity being larger than the transmissivity of the housing wall part, and
wherein the housing wall part directly adjacent to the photonic window element (21a, 21b) contains a light absorbing dope and/or light blocking dope.

2. The assembly for a semiconductor photonic component according to claim 1, wherein the recess (25) has a side wall at least partly formed by upright housing wall sections (22, 22') and has a depth D which is larger than the thickness T of the housing wall part.

3. The assembly for a semiconductor photonic component according to claim 1 or 2, wherein the recess (25) has a width W at the exterior surface and depth D, wherein D/W is such that only light rays can directly imping on the at least one photonic window at an angle smaller than a critical angle β_{critic} , wherein β_{critic} <= 40°, preferably <= 25°, more preferably <= 20°.

4. The assembly for a semiconductor photonic component according to claim 1, 2, or 3, wherein the at least one photonic window element has a transmissivity of at least 10%, preferably between 10% and 30% and the housing wall part has a transmissivity of at the most 10%, preferably between 10% and 1%, in particular at the most of 3%.

5. The assembly for a semiconductor photonic component according to any one or more of the preceding claims, wherein the housing wall part is made from a light transmissive plastic material, wherein the plastic material preferably is chosen from the group of polycarbonate, PMMA, polystyrene, styrene-acrylonitrile, polypropylene, silicone, polyurethane.

6. The assembly for a semiconductor photonic component according to any one or more of the preceding claims, wherein the housing wall part (20, 20') is formed integrally with the assembly housing (11).

7. The assembly for a semiconductor photonic component according to claim 6, wherein the housing wall part and the assembly housing form a monolithic part.

8. The assembly for a semiconductor photonic component according to claim 6, wherein the housing wall part (20, 20') is formed as an insert element in the assembly housing (11).

9. The assembly according to any one or more of the preceding claims, wherein the at least semiconductor photonic element (31, 32) comprises a light emitting element, in particular a LED, and/or a light sensing element.

10. The assembly according to claim 9, wherein the light sensing element is a photodiode, a phototransistor, or a photovoltaic cell.

11. An assembly housing (11) for use with an assembly for a semiconductor photonic component as defined in one or more of the claims 1-10.

12. A housing wall part (20, 20') for use in an assembly housing (11) as defined in one or more of the claims 1-10.

13. A luminaire (400) comprising an assembly (10) for a semiconductor photonic component as defined in one or more of the claims 1-10.

## Patentansprüche

1. Anordnung (10) für ein photonisches Halbleiterbauelement (31, 32), wobei die Anordnung mindestens umfasst:
- ein Substrat (30);
- mindestens ein photonisches Halbleiterbauelement (31, 32), das an dem Substrat montiert ist, wobei das mindestens eine photonische Halbleiterbauelement ein photonisches aktives Oberflächenelement (31a, 32a) einschließt;
- ein Anordnungsgehäuse (11) zum Abschirmen des Substrats und des mindestens einen photonischen Halbleiterbauelements von der Umgebung;
das Anordnungsgehäuse umfasst ein Gehäusewandteil (20, 20'), das eine Außenoberfläche (26) aufweist und mit mindestens einem photonischen Fensterelement (21) versehen ist, das dem photonischen aktiven Oberflächenelement (31a, 32a) des mindestens einen photonischen Halbleiterbauelements zugewandt ist, wobei das mindestens eine photonische Fensterelement eine Bodenwand einer Aussparung (25) in der Außenoberfläche ist und ein monolithisches Teil mit dem Gehäusewandteil (20, 20') bildet,
wobei das mindestens eine photonische Fensterelement (21) eine Dicke aufweist, die kleiner ist als die Dicke des Gehäusewandteils, das direkt an das mindestens eine photonische Fensterelement angrenzt, um eine Transmissivität aufzuweisen, die größer ist als die Transmissivität des Gehäusewandteils, und
wobei das Gehäusewandteil, das direkt an das photonische Fensterelement (21a, 21b) angrenzt, ein lichtabsorbierendes Dotiermittel und/oder ein lichtblockierendes Dotiermittel enthält.

2. Anordnung für ein photonisches Halbleiterbauelement nach Anspruch 1, wobei die Aussparung (25) eine Seitenwand aufweist, die mindestens teilweise durch aufrechte Gehäusewandabschnitte (22, 22') gebildet ist und eine Tiefe D aufweist, die größer als die Dicke T des Gehäusewandteils ist.

3. Anordnung für ein photonisches Halbleiterbauelement nach Anspruch 1 oder 2, wobei die Aussparung (25) eine Breite W an der Außenoberfläche und eine Tiefe D aufweist, wobei D/W so ist, dass nur Lichtstrahlen in einem Winkel kleiner als ein kritischer Winkel β_{krit.} direkt auf das mindestens eine photonische Fenster auftreffen können, wobei β_{krit.} <= 40°, vorzugsweise <= 25°, mehr bevorzugt <= 20°.

4. Anordnung für ein photonisches Halbleiterbauelement nach Anspruch 1, 2, oder 3, wobei das mindestens eine photonische Fensterelement eine Transmissivität von mindestens 10 %, vorzugsweise zwischen 10 % und 30 %, aufweist und das Gehäusewandteil eine Transmissivität von höchstens 10 %, vorzugsweise zwischen 10 % und 1 %, insbesondere von höchstens 3 %, aufweist.

5. Anordnung für ein photonisches Halbleiterbauelement nach einem oder mehreren der vorhergehenden Ansprüche, wobei das Gehäusewandteil aus einem lichtdurchlässigen Kunststoffmaterial hergestellt ist, wobei das Kunststoffmaterial vorzugsweise aus der Gruppe von Polycarbonat, PMMA, Polystyrol, Styrol-Acrylnitril, Polypropylen, Silikon, Polyurethan ausgewählt ist.

6. Anordnung für ein photonisches Halbleiterbauelement nach einem oder mehreren der vorhergehenden Ansprüche, wobei das Gehäusewandteil (20, 20') einstückig mit dem Anordnungsgehäuse (11) gebildet ist.

7. Anordnung für ein photonisches Halbleiterbauelement nach Anspruch 6, wobei das Gehäusewandteil und das Anordnungsgehäuse ein monolithisches Teil bilden.

8. Anordnung für ein photonisches Halbleiterbauelement nach Anspruch 6, wobei das Gehäusewandteil (20, 20') als ein Einsatzelement in dem Anordnungsgehäuse (11) gebildet ist.

9. Anordnung nach einem oder mehreren der vorhergehenden Ansprüche, wobei das mindestens eine photonische Halbleiterelement (31, 32) ein lichtemittierendes Element, insbesondere eine LED und/oder ein Lichterfassungselement umfasst.

10. Anordnung nach Anspruch 9, wobei das Lichterfassungselement eine Fotodiode, ein Fototransistor oder eine Photovoltaikzelle ist.

11. Anordnungsgehäuse (11) zur Verwendung mit einer Anordnung für ein photonisches Halbleiterbauelement, wie in einem oder mehreren der Ansprüche 1 bis 10 definiert.

12. Gehäusewandteil (20, 20') zur Verwendung in einem Anordnungsgehäuse (11), wie in einem oder mehreren der Ansprüche 1 bis 10 definiert.

13. Leuchte (400), umfassend eine Anordnung (10) für ein photonisches Halbleiterbauelement, wie in einem oder mehreren der Ansprüche 1 bis 10 definiert.

## Revendications

1. Ensemble (10) pour un composant photonique semi-conducteur (31, 32), l'ensemble comprenant au moins :
- un substrat (30) ;
- au moins un composant photonique semi-conducteur (31, 32) monté sur le substrat, ledit au moins un composant photonique semi-conducteur comportant un élément de surface actif photonique (31a, 32a) ;
- un boîtier d'ensemble (11) pour protéger le substrat et l'au moins un composant photonique semi-conducteur de l'environnement ;
le boîtier d'ensemble comprend une partie de paroi de boîtier (20, 20') ayant une surface extérieure (26) et étant pourvue d'au moins un élément de fenêtre photonique (21) faisant face à l'élément de surface active photonique (31a, 32a) de l'au moins un composant photonique semi-conducteur, ledit au moins un élément de fenêtre photonique étant une paroi de fond d'un évidement (25) dans ladite surface extérieure et formant une pièce monolithique avec la partie de paroi de boîtier (20, 20'),
dans lequel l'au moins un élément de fenêtre photonique (21) a une épaisseur qui est inférieure à l'épaisseur de la partie de paroi de boîtier directement adjacente à l'au moins un élément de fenêtre photonique pour avoir une transmissivité supérieure à la transmissivité de la partie de paroi de boîtier, et
dans lequel la partie de paroi de boîtier directement adjacente à l'élément de fenêtre photonique (21a, 21b) contient un dopant absorbant la lumière et/ou un dopant bloquant la lumière.

2. Ensemble pour un composant photonique semi-conducteur selon la revendication 1, dans lequel l'évidement (25) a une paroi latérale au moins partiellement formée par des sections de paroi de boîtier dressées (22, 22') et a une profondeur D qui est supérieure à l'épaisseur T de la partie de paroi de boîtier.

3. Ensemble pour un composant photonique semi-conducteur selon la revendication 1 ou 2, dans lequel l'évidement (25) a une largeur W au niveau de la surface extérieure et une profondeur D, dans lequel D/W est tel que seuls les rayons lumineux peuvent frapper directement l'au moins une fenêtre photonique à un angle inférieur à un angle critique β_{critique}, où β_{critique} <= 40°, de préférence <= 25°, plus préférentiellement <= 20°.

4. Ensemble pour un composant photonique semi-conducteur selon la revendication 1, 2, ou 3, dans lequel l'au moins un élément de fenêtre photonique a une transmissivité d'au moins 10 %, de préférence entre 10 % et 30 % et la partie de paroi de boîtier a une transmissivité d'au plus 10 %, de préférence entre 10 % et 1 %, en particulier d'au plus 3 %.

5. Ensemble pour un composant photonique semi-conducteur selon l'une ou les quelconques des revendications précédentes, dans lequel la partie de paroi de boîtier est réalisée en une matière plastique transmettant la lumière, dans lequel la matière plastique est de préférence choisie dans le groupe constitué de polycarbonate, PMMA, polystyrène, styrène-acrylonitrile, polypropylène, silicone, polyuréthane.

6. Ensemble pour un composant photonique semi-conducteur selon l'une ou les quelconques des revendications précédentes, dans lequel la partie de paroi de boîtier (20, 20') est formée d'un seul tenant avec le boîtier d'ensemble (11).

7. Ensemble pour un composant photonique semi-conducteur selon la revendication 6, dans lequel la partie de paroi de boîtier et le boîtier d'ensemble forment une pièce monolithique.

8. Ensemble pour un composant photonique semi-conducteur selon la revendication 6, dans lequel la partie de paroi de boîtier (20, 20') est formée comme un élément d'insertion dans le boîtier d'ensemble (11).

9. Ensemble selon l'une ou les quelconques des revendications précédentes, dans lequel l'au moins un élément photonique semi-conducteur (31, 32) comprend un élément émetteur de lumière, en particulier une DEL, et/ou un élément de détection de lumière.

10. Ensemble selon la revendication 9, dans lequel l'élément de détection de lumière est une photodiode, un phototransistor ou une cellule photovoltaïque.

11. Boîtier d'ensemble (11) destiné à être utilisé avec un ensemble pour un composant photonique semi-conducteur tel que défini dans une ou plusieurs des revendications 1 à 10.

12. Partie de paroi de boîtier (20, 20') destinée à être utilisée dans un boîtier d'ensemble (11) tel que défini dans une ou plusieurs des revendications 1 à 10.

13. Luminaire (400) comprenant un ensemble (10) pour un composant photonique semi-conducteur tel que défini dans une ou plusieurs des revendications 1 à 10.
